# EUROPÄISCHE PATENTSCHRIFT

(11) **EP 3 256 820 B1**
(45) Veröffentlichungstag und Bekanntmachung des Hinweises auf die Patenterteilung: **02.01.2019**
(21) Anmeldenummer: 16700578.4
(22) Anmeldetag: 13.01.2016
(51) Int. Cl.: G01D 11/24, G01D 11/30, H05K 1/14, H05K 5/00

(54) **GETRIEBESTEUERMODUL**
TRANSMISSION CONTROL MODULE
MODULE DE COMMANDE DE TRANSMISSION

(30) Priorität: 11.02.2015 DE 102015202442
(43) Veröffentlichungstag der Anmeldung: 20.12.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/050584
(87) Internationale Veröffentlichungsnummer: WO 2016/128163

(56) Entgegenhaltungen:
- DE-A1- 19 832 062
- DE-A1-102007 042 449
- DE-A1-102008 004 504
- DE-A1-102010 025 591
- DE-C1- 10 051 945

## Beschreibung

### Stand der Technik

Die Erfindung betrifft ein elektronisches Steuermodul und eine Verfahren zur Herstellung eines solchen elektronischen Steuermoduls.

In der Kraftfahrzeugtechnik werden zur Getriebesteuerung elektronische Steuermodule verwandt, die am Getriebe und im Getriebefluid angeordnet werden können. Die Steuermodule können beispielsweise elektrische Bauelemente wie Stecker, Sensoren, Aktuatoren, wenigstens ein gekapseltes Steuergerät (TCU, Transmission Control Unit) und gegebenenfalls weitere Komponenten aufweisen, die dem Getriebefluid ausgesetzt sind. Die Anordnung im Getriebefluid stellt hohe Herausforderungen an die Aufbau- und Verbindungstechnik der Baukomponenten des elektronischen Steuermoduls, da die elektrischen Verbindungen hohen Temperaturwechselbelastungen sowie dem Getriebefluid mit darin im ungünstigen Fall enthaltenen Metallspänen wiederstehen können müssen. Als elektrische Verbindungstechnik des Steuermoduls dienen umspritzte Stanzgitter sowie starre Leiterplatten oder flexible Leiterplatten (sogenannte Flexfolien). Aus der DE 101 10 620 A1 ist ein elektronisches Steuermodul bekannt, das eine flexible elektrische Leiterplatte aufweist, die eine elektrische Verbindung zwischen einem Steuergeräteteil des Steuermoduls und einem Sensorelement herstellt. Das Steuermodul weist mehrere Halteteile für Sensorelemente auf. Die flexible elektrische Leiterplatte weist wenigstens einen mit einem Sensorelement versehenen Sensorabschnitt auf, der mit dem Sensorelement elektrisch verbunden ist, wobei der mit dem Sensorelement versehene Sensorabschnitt der flexiblen elektrischen Leiterplatte zumindest abschnittsweise an dem Halteteil angeordnet ist. Die Sensorelemente werden zu diesem Zweck in Aussparungen der Halteteile bündig eingeklipst.

DE 100 51 945 C1 offenbart ein weiteres elektronisches Steuermodul mit einer flexiblen Leiterplatte.

### Offenbarung der Erfindung

Die Erfindung betrifft ein elektronisches Steuermodul, insbesondere für eine Getriebesteuerung, mit einer flexiblen elektrischen Leiterplatte, die eine elektrische Verbindung zwischen einem Steuergeräteteil und einem Sensorelement herstellt, und mit einem Halteteil für das Sensorelement, wobei die flexible elektrische Leiterplatte einen mit dem Sensorelement versehenen Sensorabschnitt aufweist, der mit dem Sensorelement elektrisch verbunden ist, wobei der mit dem Sensorelement versehene Sensorabschnitt der flexiblen elektrischen Leiterplatte zumindest abschnittsweise an dem Halteteil angeordnet ist. Ein mit dem Sensorelement versehener Sensorabschnitt ist unter Zwischenlage eines an dem Sensorabschnitt befestigten Plättchens auf das Halteteil aufgesetzt ist und das Plättchen ist mittels wenigstens einer Schweißverbindung an dem Halteteil festgelegt.

Weiterhin betrifft die Erfindung ein Verfahren zur Herstellung eines elektronischen Steuermoduls, insbesondere für eine Getriebesteuerung, bei dem ein Halteteil und eine flexible elektrische Leiterplatte mit einem Sensorabschnitt bereitgestellt werden. An dem Sensorabschnitt sind ein damit elektrisch verbundenes Sensorelement und ein Plättchen befestigt. Der Sensorabschnitt wird derart auf das Halteteil montiert, dass das Plättchen zwischen dem Halteteil und dem Sensorabschnitt positioniert ist. Anschließend wird wenigstens eine Schweißverbindung zwischen dem Plättchen und dem Halteteil hergestellt.

### Vorteile der Erfindung

Vorteilhaft wird durch die Erfindung erreicht, dass ein mit dem Sensorelement versehener Sensorabschnitt der flexiblen elektrischen Leiterplatte an einem zugeordneten Halteteil besonders einfach und zuverlässig festgelegt werden kann. Dabei wird sowohl vorteilhaft das Handling eines mit einem Sensorelement versehenen Sensorabschnitts vereinfacht als auch eine verbesserte und einfache Fixierung des mit einem Sensorelement versehenen Sensorabschnitts an dem zugeordneten Halteteil ermöglicht. Die aus dem mit dem Sensorelement versehenen Sensorabschnitt der flexiblen elektrischen Leiterplatte gebildete Baugruppe kann einfach und kostengünstig in hoher Variantenvielfalt verbaut werden und ermöglicht einen wirksamen Schutz des Sensors gegen Späne und Getriebeöl. Ein mit dem Sensorelement versehener Sensorabschnitt der flexiblen elektrischen Leiterplatte wird in einfacher Weise an einer Seite mit einem Plättchen versehen, das an dem Sensorabschnitt befestigt wird. Das Plättchen bewirkt vorteilhaft eine Versteifung des mit dem Sensorelement versehenen Sensorabschnitts und erleichtert dadurch dessen Handhabung bei der Montage am Halteteil des Steuermoduls. Das Plättchen kann sowohl an der von dem Sensorelement abgewandten Seite des Sensorabschnitts der flexiblen elektrischen Leiterplatte als auch an der mit dem Sensorelement versehenen Seite des Sensorabschnitts der flexiblen elektrischen Leiterplatte befestigt werden. Das Plättchen kann durch einfache und preiswerte Verfahren wie beispielsweise Kleben, Laminieren oder Umspritzen an dem Sensorabschnitt befestigt werden. Die Fixierung des mit dem Plättchen versehenen Sensorabschnitts an dem Halteteil erfolgt dann in einfacher Weise durch einen Schweißvorgang, bei dem das Plättchen an wenigstens einer Stelle, vorzugsweise an mehreren Stellen mit dem Halteteil verschweißt wird.

Vorteilhafte Ausgestaltungen und Weiterentwicklungen der Erfindung werden durch die in den abhängigen Ansprüchen enthaltenen Merkmale ermöglicht.

Vorteilhaft ist das Plättchen aus Kunststoff gefertigt. Kunststoff ermöglicht einerseits eine einfache und zuverlässige Befestigung des Plättchens an der flexiblen Leiterplatte und andererseits ein besonders einfaches Aufschweißen des Plättchens an dem Halteteil.

Vorteilhaft kann das Sensorelement auf einer von dem Plättchen abweisenden Seite des Sensorabschnitts angeordnet sein. In diesem Fall kann es vorteilhaft sein, das Sensorelement durch eine an dem Sensorabschnitt über dem Sensorelement angeordnet Schutzabdeckung nach außen vor Getriebeöl und Spänen zu schützen.

Es ist aber auch möglich, das Sensorelement auf der dem Plättchen zuweisenden Seite des Sensorabschnitts der flexiblen Leiterplatte in einer Aussparung des Plättchens anzuordnen. Die Aussparung mit dem darin eingesetzten Sensorelement wird dann von dem Sensorabschnitt abgedeckt, der beispielsweise auf das Plättchen auflaminiert oder aufgeklebt werden kann, so dass die Aussparung in dem Plättchen völlig abgedichtet ist.

Vorteilhaft kann ein mit dem Sensorelement zusammenwirkender Permanentmagnet in das Plättchen integriert sein.

Um einen einfachen Schweißvorgang durchzuführen und eine Beschädigung der flexiblen Leiterplatte zu vermeiden, können in dem Sensorabschnitt der flexiblen Leiterplatte außerhalb des mit dem Sensorelement versehenen Bereichs Aussparungen vorhanden sein, durch welche das Plättchen von der von dem Halteteil abweisenden Seite des Sensorabschnitt aus zugänglich ist. Mit einer Schweißvorrichtung, insbesondere einer Laserschweißvorrichtung, kann dann vorteilhaft innerhalb der Aussparung das Plättchen aufgeschmolzen werden und mit dem darunter angeordneten Halteteil verschweißt werden.

Besonders vorteilhaft ist es, wenn nicht nur das Plättchen sondern auch das Halteteil aus Kunststoff gefertigt ist. In diesem Fall ist die Herstellung einer Schweißverbindung zwischen dem Plättchen und dem Halteteil insbesondere durch Laserschweißen besonders einfach herstellbar.

### Kurze Beschreibung der Zeichnungen

Ausführungsbeispiele der Erfindung sind in den Zeichnungen dargestellt und werden in der nachfolgenden Beschreibung näher erläutert.

### Es zeigen

Fig. 1 einen Querschnitt durch einen Teil eines erfindungsgemäßen Steuermoduls mit einem Halteteil für ein erstes Ausführungsbeispiel,
Fig. 2 einen Querschnitt durch einen Teil eines erfindungsgemäßen Steuermoduls mit einem Halteteil für ein zweites Ausführungsbeispiel,
Fig. 3 das Halteteil aus Fig. 1 in Draufsicht,
Fig. 4 das Halteteil aus Fig. 2 in Draufsicht.

### Ausführungsformen der Erfindung

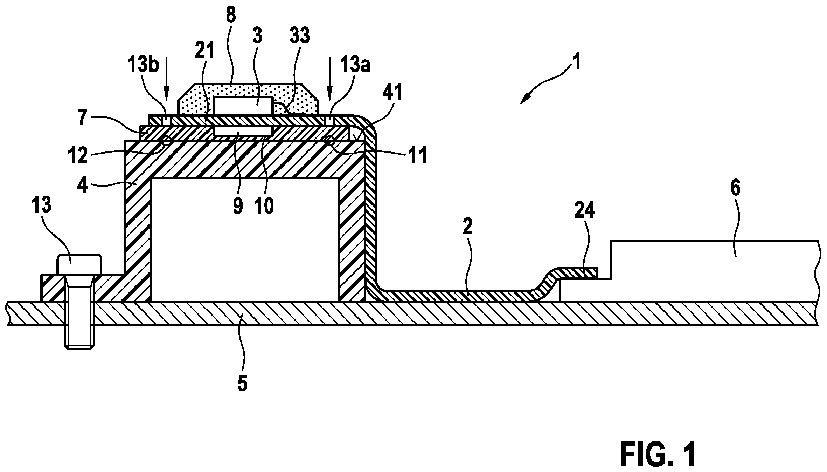

Fig. 1 zeigt ein erstes Ausführungsbeispiel eines erfindungsgemäßen elektronischen Steuermoduls, welches beispielsweise in einem Getriebe zu Ansteuerung von Aktuatoren der Getriebesteuerung verbaut werden kann. In dem hier gezeigten Ausführungsbeispiel umfasst das elektronische Steuermodul 1 beispielsweise eine Trägerplatte 5, vorzugsweise aus Aluminium. An der Trägerplatte 5, die nicht notwendig vorgesehen ist, können beispielsweise alle oder nur einige Baugruppen des Steuermoduls angeordnet sein. Ein Steuergeräteteil 6 des Steuermoduls 1 beinhaltet eine elektronische Steuerschaltung, die sogenannte TCU (Transmission control unit), und dient zur Ansteuerung der diversen Aktuatoren (in Fig. 1 nicht gezeigt) und Sensoren des Steuermoduls. Zu diesem Zweck ist das Steuermodul 1 mit Sensorelementen 3 und hier nicht dargestellten Aktuatoren über elektrische Verbindungsmittel kontaktiert. Hierzu dienen eine oder mehrere flexible elektrische Leiterplatten 2, die auch als Leiterfolie bezeichnet werden (FPC = flexible printed circuit board).

Eine flexible elektrische Leiterplatte umfasst wenigstens eine flexible Trägerfolie aus beispielsweise Polyimid oder Polyester, die mit dünnen Leiterbahnen aus beispielweise Kupfer beschichtet ist. Die Kupferleiterbahnen sind beispielsweise durch eine flexible Isolationsschicht oder Folie abgedeckt.

Die flexible elektrische Leiterplatte 2 ist mit dem Steuergeräteteil 6 an Verbindungstellen 24 elektrisch kontaktiert. Hierfür können bekannte Kontaktierungstechniken wie Löten oder Schweißen eingesetzt werden, auf die hier nicht eingegangen zu werden braucht. Die flexible Leiterplatte 2 kann einen oder mehrere Sensorabschnitte 21 aufweisen. Es ist möglich, dass die flexible Leiterplatte 2 nur zur Anbindung eines einzelnen Sensorelementes 3 an den Steuergeräteteil 6 dient oder aber mehrere Sensorabschnitte 21 zur Anbindung mehrere Sensorelemente 3 an den Steuergeräteteil 6 aufweist. Ebenso kann die flexible elektrische Leiterplatte 2 weitere hier nicht dargestellte Abschnitte zur Anbindung von Aktuatoren aufweisen. Die Anbindung der Aktuatoren an den Steuergeräteteil 6 kann aber natürlich auch durch separate flexible Leiterplatten erfolgen. Die flexible elektrische Leiterplatte 2 kann abschnittsweise auf die Trägerplatte 5 auflaminiert oder aufgeklebt sein, wobei der Sensorabschnitt 21 der flexiblen elektrischen Leiterplatte 2 an einem Halteteil 4 befestigt wird, wie noch erläutert wird.

Wie in Fig. 1 zu erkennen ist, ist das Halteteil 4 über Befestigungsmittel 13 mit der Trägerplatte 5 verbunden. Das Halteteil 4 kann aus einem schweißfähigen Werkstoff wie Metall bestehen, besteht aber vorzugsweise aus einem schweißfähigen Kunststoff. Das Halteteil 4 dient zur Montage eines Sensorelementes 3. Durch die Befestigung des Sensorelementes 3 an dem Halteteil 4 entsteht ein sogenannter Sensordom, der einen von der Trägerplatte 5 abstehenden Vorsprung bildet, welcher bei der Montage des elektronischen Steuermoduls 1 am Getriebe in entsprechend ausgebildete Öffnungen des Getrieberaums eingreift, um das Sensorelement in der erforderlichen Einbaulage in der Nähe eines Messwertgebers zu positionieren. Bei dem Sensorelement 3 kann es sich beispielsweise um einen Drehzahlsensor handeln, der geeignet ausgebildet ist, um die Drehzahl eines Geberrades zu erfassen. Insbesondere kann das Sensorelement 3 ein Hall-IC oder Sensor-ASIC mit integriertem Hallsensorelement sein.

Bei dem Ausführungsbeispiel von Fig. 1 ist das Sensorelement 3 auf dem Sensorabschnitt 21 der flexiblen elektrischen Leiterplatte 2 aufgesetzt. Elektrische Anschlüsse 33 des Sensorelementes 3 sind mit den (nicht dargestellten) Leiterbahnen der flexiblen elektrischen Leiterplatte 2 kontaktiert. Das an dem Sensorabschnitt 21 angeordnete Sensorelement 3 ist durch eine Schutzabdeckung 8 abgedeckt. Bei der Schutzabdeckung 8 kann es sich beispielsweise um einen Globe-Top-Lack, ein Epoxidharz oder eine Polyacrylatmasse oder eine dichtende Kappe handeln. Darin ist keine Beschränkung auf die hier aufgezählten Ausführungsformen zu sehen. Wichtig ist, dass das Sensorelement 3 auf dem Sensorabschnitt 21 der flexiblen elektrischen Leiterplatte 2 nach außen gegen ein Getriebefluid geschützt ist.

Auf der von dem Sensorelement 3 abgewandten Seite des Sensorabschnitts 21 weist die flexible elektrische Leiterplatte 2 ein Plättchen 7 auf. Das Plättchen kann aus Metall bestehen, besteht aber vorzugsweise aus Kunststoff und ist an dem Sensorabschnitt 21 der flexiblen elektrischen Leiterplatte 2 beispielsweise durch Kleben oder Laminieren befestigt. Das Plättchen 7 ist vorzugsweise als dünne planparallele Platte ausgebildet, kann aber auch andere Formen aufweisen, die aufgrund ihrer Form und Dicke geeignet sind, mittels eines das Plättchen durchringenden Laserstrahls auf das Halteteil 4 aufgeschweißt zu werden.

Das Plättchen 7 kann eine Aussparung 10 aufweisen, in der ein Permanentmagnet 9 angeordnet ist. Wie in Fig. 1 zu erkennen ist, ist das Sensorelement 3 auf der von dem Permanentmagneten 9 abgewandten Seite der flexiblen elektrischen Leiterplatte 2 montiert.

Der Sensorabschnitt 21 der flexiblen elektrischen Leiterplatte 2 wird mit dem Plättchen 7 auf die Stirnseite 41 des Haltteils 4 flach aufgelegt. Die Stirnseite 41 ist die von der Trägerplatte 5 abgewandte Seite des Halteteils 4, welche vorzugsweise eben ausgebildet ist. Beispielsweise mittels eine Laserstrahls, dessen Strahlrichtung entlang der in Fig. 1 gezeigten Pfeile senkrecht auf die Stirnseite 41 gerichtet ist, wird das Plättchen 7 mit dem Halteteil 4 verschweißt. Dabei entstehen beispielsweise zwei Schweißverbindungen 11 und 12 zwischen dem Plättchen 7 und dem Halteteil 4.

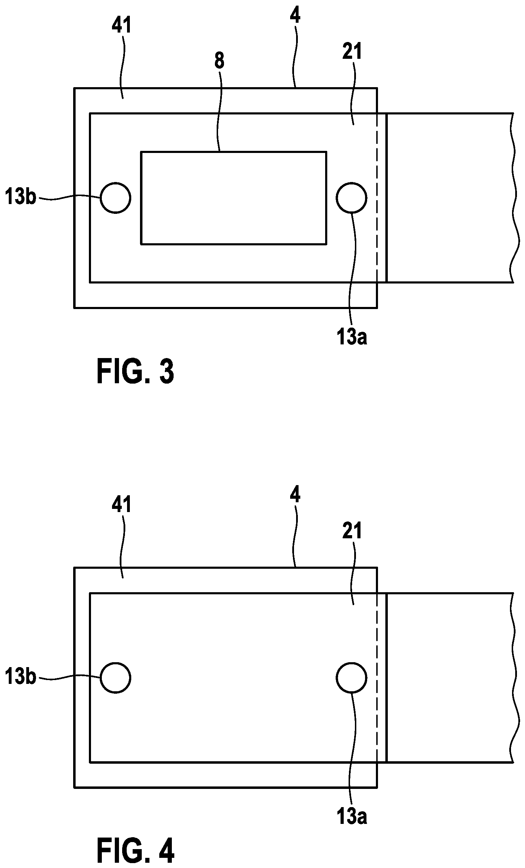

In Fig. 3 ist die Anordnung in Draufsicht zu sehen. Obwohl es möglich ist mit dem Laser durch die flexible elektrische Leiterplatte 2 hindurch das Plättchen 7 mit dem Halteteil 4 zu verschweißen, wobei vorzugsweise eine Wellenlänge des Laserlichts verwandt wird, die das Material der flexiblen elektrischen Leiterplatte 2 durchdringt, ohne dieses zu beschädigen (sogenanntes Laser-Durchlichtschweißen) ist es besonders einfach, wenn der Sensorabschnitt 21 der flexiblen elektrischen Leiterplatte 2 außerhalb des mit dem Sensorelement 3 und der Schutzabdeckung 8 versehenen Bereichs Aussparungen 13a, 13b aufweist, durch die das Plättchen 7 von außen zugänglich ist. In Fig. 1 und Fig. 3 ist erkennbar, dass der Laserstrahl in den Aussparungen 13a, 13b auf das Plättchen 7 trifft, dieses lokal aufschmilzt und mit dem Halteteil 4 verbindet, wodurch die Schweißverbindungen 11 und 12 entstehen. Dabei kann ergänzend oder alternativ auch vorgesehen sein, die dem Plättchen 7 zugewandte Seite des Halteteils 4 aufzuschmelzen. Bestehen Plättchen 7 und Halteteil 4 aus Kunststoff, können beide Teile aufgeschmolzen werden oder alternativ unter Verwendung des Laser-Durchlichtschweißverfahren das Plättchen durchleutet werden, während das darunter liegende Halteteil partiell aufgeschmolzen wird. Wichtig ist, dass eine feste Verbindung zwischen dem Plättchen 7 und dem Halteteil 4 am Ort der Schweißverbindungen 11, 12 entsteht. Natürlich kann die Anzahl und die genaue Lage der Schweißverbindungen variiert werden.

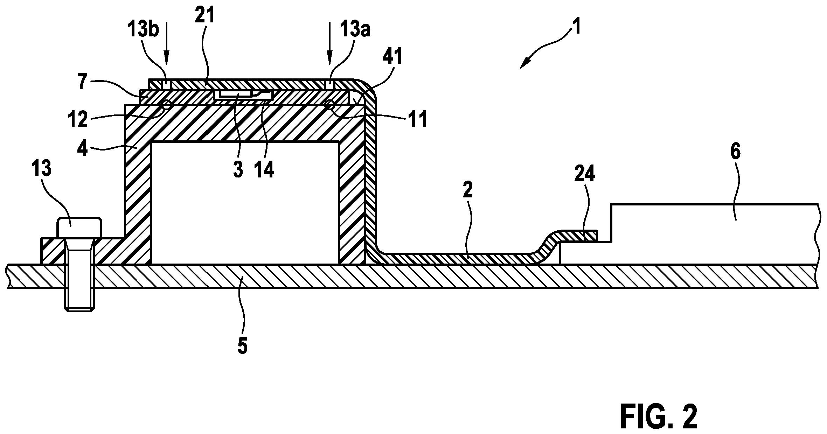

Ein zweites Ausführungsbeispiel der Erfindung ist in den Fig. 2 und Fig. 4 dargestellt. Der einzige Unterschied zu dem in Fig. 1 und Fig. 3 gezeigten ersten Ausführungsbeispiel besteht darin, dass das Sensorelement 3 auf der dem Plättchen 7 und dem Halteteil 4 zuweisenden Seite des Sensorabschnitts 21 der flexiblen elektrischen Leiterplatte 2 montiert ist. Zu diesem Zweck weist das Plättchen 7 eine Aussparung 14 auf, in die das Sensorelement 3 beim Auflegen des Sensorabschnitts 21 der flexiblen elektrischen Leiterplatte 2 auf das Plättchen eingreift. Der Rand des Sensorabschnitts 21 ist um die Aussparung 14 herum so auf das Plättchen 7 auflaminiert oder aufgeklebt, dass das Sensorelement 3 in der Aussparung 14 vor Getriebefluid geschützt angeordnet ist.

Ebenso wie bei dem Ausführungsbespiel von Fig. 1 und Fig. 3 wird beispielsweise mit einem Laserstrahl oder einem anderen geeigneten Schweißwerkzeug durch Aussparungen 13a, 13b hindurch das Plättchen 7 lokal aufgeschmolzen und mit dem Halteteil 4 verschweißt. Auch hier kann auf die Aussparungen 13a, 13b verzichtet werden und mit einem Laserstrahl geeigneter Wellenlänge direkt durch die flexible elektrische Leiterplatte hindurch das Plättchen mit dem Halteteil verschweißt werden.

## Patentansprüche

1. Elektronisches Steuermodul (1), insbesondere für eine Getriebesteuerung, mit einem Sensorelement (3) und einer flexiblen elektrischen Leiterplatte (2), die eine elektrische Verbindung zwischen einem Steuergeräteteil (6) und dem Sensorelement (3) herstellt, und mit einem Halteteil (4) für das Sensorelement (3), wobei die flexible elektrische Leiterplatte (2) einen mit dem Sensorelement (3) versehenen Sensorabschnitt (21) aufweist, der mit dem Sensorelement (3) elektrisch verbunden ist, wobei der mit dem Sensorelement (3) versehene Sensorabschnitt (21) der flexiblen elektrischen Leiterplatte (2) zumindest abschnittsweise an dem Halteteil (4) angeordnet ist, **dadurch gekennzeichnet, dass** der mit dem Sensorelement (3) versehene Sensorabschnitt (21) der flexiblen elektrischen Leiterplatte (2) unter Zwischenlage eines an dem Sensorabschnitt (21) befestigten Plättchens (7) auf das Halteteil (4) aufgesetzt ist und das Plättchen (7) mittels wenigstens einer Schweißverbindung (11, 12) an dem Halteteil (4) festgelegt ist.

2. Elektronisches Steuermodul nach Anspruch 1, **dadurch gekennzeichnet, dass** das Plättchen (7) aus Kunststoff gefertigt ist.

3. Elektronisches Steuermodul nach einem der Ansprüche 1 oder 2, **dadurch gekennzeichnet, dass** das Sensorelement (3) auf einer von dem Plättchen (7) abweisenden Seite des Sensorabschnitts (21) angeordnet ist.

4. Elektronisches Steuermodul nach Anspruch 3, **dadurch gekennzeichnet, dass** das Sensorelement (3) durch eine an dem Sensorabschnitt (21) angeordnete Schutzabdeckung (8) abgedeckt ist.

5. Elektronisches Steuermodul nach Anspruch 1 oder 2, **dadurch gekennzeichnet, dass** das Sensorelement (3) auf der dem Plättchen (7) zuweisenden Seite des Sensorabschnitts (21) der flexiblen Leiterplatte (2) und in einer Aussparung (14) des Plättchens (7) angeordnet ist, die von dem Sensorabschnitt (21) abgedeckt wird.

6. Elektronisches Steuermodul nach Anspruch 2, **dadurch gekennzeichnet, dass** ein Permanentmagnet (9) in dem Plättchen (7) integriert ist.

7. Elektronisches Steuermodul nach einem der Ansprüche 1 bis 6, **dadurch gekennzeichnet, dass** in dem Sensorabschnitt (21) der flexiblen Leiterplatte (2) außerhalb des mit dem Sensorelement (3) versehenen Bereichs Aussparungen (13a, 13b) vorhanden sind, durch welche das Plättchen (7) von einer von dem Halteteil (4) abweisenden Seite des Sensorabschnitt (21) aus zugänglich ist.

8. Elektronisches Steuermodul nach einem der Ansprüche 1 oder 7, **dadurch gekennzeichnet, dass** das Halteteil (4) aus Kunststoff gefertigt ist.

9. Verfahren zur Herstellung eines elektronischen Steuermoduls (1), insbesondere für eine Getriebesteuerung,
**gekennzeichnet durch** folgende Schritte:
- Bereitstellen eines Halteteils (4),
- Bereitstellen einer flexiblen elektrischen Leiterplatte (2) mit einem Sensorabschnitt (21), an dem ein mit dem Sensorabschnitt (21) elektrisch verbundenes Sensorelement (3) angeordnet ist und an dem ein Plättchen (7) befestigt ist,
- Montage des Sensorabschnitts (21) auf dem Halteteil (4) derart, dass das Plättchen (7) zwischen dem Halteteil (4) und dem Sensorabschnitt (21) positioniert ist,
- Herstellen wenigstens einer Schweißverbindung (11, 12) zwischen dem Plättchen (7) und dem Halteteil (4).

10. Verfahren nach Anspruch 9, **dadurch gekennzeichnet, dass** das Plättchen (7) und/oder das Halteteil (4) aus Kunststoff gefertigt sind.

## Claims

1. Electronic control module (1), in particular for a transmission controller, having a sensor element (3) and a flexible electrical circuit board (2) which establishes an electrical connection between a control unit part (6) and the sensor element (3), and having a holding part (4) for the sensor element (3), wherein the flexible electrical circuit board (2) has a sensor section (21) which is provided with the sensor element (3) and is electrically connected to the sensor element (3), wherein the sensor section (21) provided with the sensor element (3) of the flexible electrical circuit board (2), is arranged at least partially on the holding part (4), **characterized in that** the sensor section (21) provided with the sensor element (3) of the flexible electrical circuit board (2), is fitted onto the holding part (4) with intermediate positioning of a small plate (7) which is attached to the sensor section (21), and the small plate (7) is secured to the holding part (4) by means of at least one welded connection (11, 12).

2. Electronic control module according to Claim 1, **characterized in that** the small plate (7) is fabricated from plastic.

3. Electronic control module according to one of Claims 1 or 2, **characterized in that** the sensor element (3) is arranged on a side of the sensor section (21) which points away from the small plate (7).

4. Electronic control module according to Claim 3, **characterized in that** the sensor element (3) is covered by a protective cover (8) which is arranged on the sensor section (21).

5. Electronic control module according to Claim 1 or 2, **characterized in that** the sensor element (3) is arranged on that side of the sensor section (21) of the flexible circuit board (2) which points towards the small plate (7), and is arranged in a cutout (14) in the small plate (7), which cutout (14) is covered by the sensor section (21).

6. Electronic control module according to Claim 2, **characterized in that** a permanent magnet (9) is integrated into the small plate (7).

7. Electronic control module according to one of Claims 1 to 6, **characterized in that** cutouts (13a, 13b) through which the small plate (7) is accessible from a side of the sensor section (21) which points away from the holding part (4) are present in the sensor section (21) of the flexible circuit board (2), outside the region provided with the sensor element (3).

8. Electronic control module according to one of Claims 1 or 7, **characterized in that** the holding part (4) is fabricated from plastic.

9. Method for manufacturing an electronic control module (1), in particular for a transmission controller, **characterized by** the following steps:
- making available a holding part (4),
- making available a flexible electrical circuit board (2) with a sensor section (21) on which a sensor element (3) which is electrically connected to the sensor section (21) is arranged, and to which a small plate (7) is attached,
- mounting of the sensor section (21) on the holding part (4) such that the small plate (7) is positioned between the holding part (4) and the sensor section (21),
- manufacturing at least one welded connection (11, 12) between the small plate (7) and the holding part (4).

10. Method according to Claim 9, **characterized in that** the small plate (7) and/or the holding part (4) are/is fabricated from plastic.

## Revendications

1. Module de commande électronique (1), destiné en particulier à commander une transmission, comprenant un élément capteur (3) et une carte de circuit imprimé électrique flexible (2) qui établit une liaison électrique entre un élément de commande (6) et l'élément capteur (3), et comprenant un élément de retenue (4) de l'élément capteur (3), dans lequel la carte de circuit imprimé électrique flexible (2) comporte une partie capteur (21) qui est pourvue de l'élément capteur (3) et est reliée électriquement à l'élément capteur (3), dans lequel la partie capteur (21) de la carte de circuit imprimé électrique flexible (2) pourvue de l'élément capteur (3) est disposée au moins par endroits sur l'élément de retenue (4),
**caractérisé en ce que** la partie capteur (21), pourvue de l'élément capteur (3), de la carte de circuit imprimé électrique flexible (2) est placée sur l'élément de retenue (4) avec interposition d'une plaquette (7) fixée à la partie capteur (21) et **en ce que** la plaquette (7) est fixée à l'élément de retenue (4) au moyen d'au moins une liaison par soudage (11, 12).

2. Module de commande électronique selon la revendication 1, **caractérisé en ce que** la plaquette (7) est constituée de matière plastique.

3. Module de commande électronique selon l'une des revendications 1 ou 2, **caractérisé en ce que** l'élément capteur (3) est disposé sur un côté de la partie capteur (21) qui est tourné à l'opposé de la plaquette (7).

4. Module de commande électronique selon la revendication 3, **caractérisé en ce que** l'élément capteur (3) est recouvert par un couvercle de protection (8) disposé sur la partie capteur (21).

5. Module de commande électronique selon la revendication 1 ou 2, **caractérisé en ce que** l'élément capteur (3) est disposé sur le côté de la partie capteur (21) de la carte de circuit imprimé flexible (2) qui est tourné vers la plaquette (7) et dans un évidement (14) de la plaquette (7) qui est recouvert par la partie capteur (21).

6. Module de commande électronique selon la revendication 2, **caractérisé en ce qu'**un aimant permanent (9) est intégré dans la plaquette (7).

7. Module de commande électronique selon l'une des revendications 1 à 6, **caractérisé en ce qu'**il est prévu dans la partie capteur (21) de la carte de circuit imprimé flexible (2), à l'extérieur de la zone pourvue de l'élément capteur (3), des évidements (13a, 13b) à travers lesquels la plaquette (7) est accessible depuis un côté de la partie capteur (21) qui est tourné à l'opposé de l'élément de retenue (4).

8. Module de commande électronique selon l'une des revendications 1 ou 7, **caractérisé en ce que** l'élément de retenue (4) est constitué de matière plastique.

9. Procédé pour réaliser un module de commande électronique (1), destiné à commander en particulier une transmission, **caractérisé en ce qu'**il comporte les étapes consistant à :
- prévoir un élément de retenue (4),
- prévoir une carte de circuit imprimé électrique flexible (2) comprenant une partie capteur (21) sur laquelle est disposé un élément capteur (3) relié électriquement à la partie capteur (21) et auquel est fixée une plaquette (7),
- monter la partie capteur (21) sur l'élément de retenue (4) de manière à ce que la plaquette (7) soit positionnée entre l'élément de retenue (4) et la partie capteur (21),
- réaliser au moins une liaison par soudage (11, 12) entre la plaquette (7) et l'élément de retenue (4).

10. Procédé selon la revendication 9, **caractérisé en ce que** la plaquette (7) et/ou l'élément de retenue (4) sont constitués de matière plastique.
